(19)

**Europäisches Patentamt**
**European Patent Office**
**Office européen des brevets**

(11) **EP 4 525 238 A1**

(12) **EUROPEAN PATENT APPLICATION**

(43) Date of publication:
**19.03.2025  Bulletin 2025/12**

(51) International Patent Classification (IPC):
***H02H 7/12*** *(2006.01)*

(21) Application number: **23197916.2**

(52) Cooperative Patent Classification (CPC):
**H02H 7/1216; H02M 1/0009; H02M 1/0064;**
**H02M 1/32; H02M 3/1584**

(22) Date of filing: **18.09.2023**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(71) Applicant: **Infineon Technologies Austria AG**
**9500 Villach (AT)**

(72) Inventors:
• **RIZZOLATTI, Roberto**
**9523 Villach (AT)**
• **URSINO, Mario**
**9500 Villach (AT)**
• **PELUSO, Luca**
**9500 Villach (AT)**

(74) Representative: **Elkington and Fife LLP**
**Prospect House**
**8 Pembroke Road**
**Sevenoaks, Kent TN13 1XR (GB)**

(54)  **OVERCURRENT PROTECTION**

(57)     A system (1000-1, 1000-2, 1000-3) is provided
for overcurrent protection of a multi-phase trans-inductance voltage regulator (100-1, 100-2, 100-3, 100-4). The
multi-phase trans-inductance voltage regulator comprises a plurality of transformers (110-1, 110-2, 110-3),
each transformer comprising a primary inductor (112-1,
112-2, 112-N) and a secondary inductor (114-1, 114-2,
114-N). The primary inductor of each transformer is
provided between a respective input node (120-1,
120-2, 120-N) and a common output node (130), and
the secondary inductors of the plurality of transformers
are connected in series. Each input node is connected to
a respective one of a plurality of phase inputs. The
system includes a first sensor arrangement (200-1,
200-2, 200-3) configured to measure a current flowing
through the secondary inductors. The system also in-
cludes a controller (300) configured to generate an overcurrent fault signal based at least in part on the measured
current flowing through the secondary inductors. Also
disclosed is a multi-phase trans-inductance voltage reg-
ulator including the system, and an associated controller
and method for overcurrent protection of a multi-phase
trans-inductance voltage regulator.

FIG. 7

EP 4 525 238 A1

**Description**

FIELD OF THE INVENTION

This invention relates to systems and methods for overcurrent protection for power converters. In particular, it relates to overcurrent protection of a multi-phase trans-inductance voltage regulator.

BACKGROUND OF THE INVENTION

Many modern microprocessors demand very high currents. For example, in AI applications, hardware accelerators are used which require high power, and therefore draw high current, over short periods of time. Voltage regulators for such accelerators must be able to handle high instantaneous peak power/current over a short period of time.

The thermal impact on the voltage regulator is determined by the thermal design current (TDC) operating point. However, in many ASICs/GPUs the peak required current can be double the TDC, meaning that the inductors of the regulator need to be larger to avoid saturation. There is hence the need to mitigate the dependency between peak current requirement and inductor size.

Recently, a multi-phase trans-inductor voltage regulator (TLVR) has been proposed for delivering power from an input voltage to the output (e.g., the point-of-load). Rather than using uncoupled individual inductors in each stage of the multi-phase converter, each stage uses a transformer where the primary inductor is coupled between a half-bridge and the point-of-load, and all secondary inductors are connected in series and referenced to ground. The coupling between the primary and secondary inductors is near-perfect with coupling coefficients close to unity.

In contrast to a conventional multi-phase converter, in a TLVR a load jump leading to an increase of the equivalent duty cycle in one phase (and hence to an increase of current in this phase) results in an increase of output current in all phases. This inherent feature of the TLVR allows a much faster transient response corresponding to a significantly lower effective output inductance of the system.

The inventors have identified a need for an overcurrent protection scheme for a TLVR, which enables high current throughput without increasing inductor size.

SUMMARY OF THE INVENTION

According to one aspect of the invention, there is provided a system for overcurrent protection of a multi-phase trans-inductance voltage regulator. The multi-phase trans-inductance voltage regulator comprises a plurality of transformers, each transformer comprising a primary inductor and a secondary inductor, wherein the primary inductor of each transformer is provided between a respective input node and a common output node, the secondary inductors of the plurality of transformers are connected in series, and wherein each input node is connected to a respective one of a plurality of phase inputs. The system comprises:

> a first sensor arrangement configured to measure a current flowing through the secondary inductors; and
> a controller configured to generate an overcurrent fault signal based at least in part on the measured current flowing through the secondary inductors.

By way of explanation, when there is an increase in the current required by the load on the output node of the trans-inductance voltage regulator (TLVR), a controller of the TLVR compensates the output load by increasing the duty cycle for the phase inputs (when a constant frequency controller is used), thereby increasing a supplied current to the output node. For a multi-phase TLVR, this means that the secondary inductors (i.e. secondary windings, or inductors on the secondary side) are energised. Initially, a part of the load current is supported by the leakage current of each transformer. This means that the current flowing through the secondary inductors (i.e., present on the secondary side) enables the primary inductors to (temporarily) withstand a load current above the rated inductor saturation current. This can be seen in the following equation, which is always valid:

$$i_{ph,i}(t) = i_{L_{secondary}}(t) + i_{L_{m_{1,i}}}(t) \qquad [1]$$

Where $i_{ph,i}(t)$ is the phase input current for transformer $i$, $i_{L_{secondary}}(t)$ is the current flowing through the secondary inductors/secondary windings connected in series, , and $i_{L_{m_{1,i}}}(t)$ is the current supported by the magnetizing inductance of the primary inductor of transformer $i$.

It is worth noting that the current flowing on the secondary side decreases with time after a phase current input increase, since the secondary side presents a resistive behaviour. Therefore, the current drops to zero according to the following decay constant:

$$\tau = \frac{DCR_{tr}}{L_{tr} + \sum_{i=1}^{N}\left(L_{k2,i} + L_{m2,i}\right)} \qquad [2]$$

Where $DCR_{tr}$ is the combined DCR resistance of the inductors connected on the secondary side, and distributed resistance of interconnection of all the secondary inductors and connection to ground, $L_{k2,i}$ is the leakage inductance of the secondary inductor of transformer i, $L_{k2,i}$ is the magnetizing inductance of the secondary inductor of transformer i, and $L_{tr}$ is the inductance of any additional inductors (e.g., compensation inductor(s)) on the secondary side.

Accordingly, the controller generates the overcurrent fault signal based on the current flowing through the secondary inductors. The overcurrent fault signal may be indicative of a risk of an overcurrent fault.

For example, when the current flowing through the secondary inductors (i.e. the current on the secondary side) is high, this indicates that the current built into the magnetizing inductance of each primary inductor is low. This is because the phase current through each primary inductor is partially supported by the high leakage current of each transformer. Essentially, this means that the primary inductors are each able to handle a current greater that the rated inductor saturation current due to the high leakage current of the transformers. Accordingly, the overcurrent fault signal may not be, or is less likely to be, generated when the current flowing through the secondary inductors is high.

Conversely, when there is little or no current flowing through the secondary inductors, this is indicative of little or no leakage current in each transformer, and therefore the current supplied by the phase input is entirely supported by the magnetizing inductance of the primary inductor. A high current supported by the magnetizing inductance of the primary inductor may result in an overcurrent fault. Accordingly, the overcurrent fault signal may be, or may more likely be, generated when the current flowing through the secondary inductors is low.

The output node may be connected to a load. The load may be a variable load requiring a differing current with time. Accordingly, the overcurrent protection system may be able to protect the multi-phase trans-inductance voltage regulator when the current required by the load increases.

The first sensor arrangement may be any means capable of measuring a current flowing through the secondary inductors. This may include generation of a voltage proportional to the current on the secondary side by the first sensor arrangement, conversion of said voltage to a numerical value, and conversion of said numerical value to an absolute or relative current reading.

The first sensor arrangement may be configured to measure the current, and the controller configured to generate the overcurrent fault signal responsive to an increase in the current provided by one or more phase inputs of the multi-phase converter.

The controller may control one or more switching elements connected to an input voltage to provide each phase input. That is, for each of the plurality of phase inputs, the controller may be controlling one or more switching elements to provide the phase input at the respective input node. For example, the one or more switching elements may be in the form of a half bridge with each switching element associated with a gate drive controlled by the controller to determine a switching frequency. Said switching frequency and duty cycle may determine the phase current provided to each input node.

The system may further comprise a second sensor arrangement configured, for at least two of the plurality of phase inputs, to measure phase currents provided by the phase inputs. In this case, the controller may be configured to generate the overcurrent fault signal further based on at least one of the measured phase currents.

This measurement may be performed by typical implementations of controllers for multi-phase regulators, and the second sensor arrangement hardware may form part of the controller. Nevertheless, it is worth noting that, in some examples, the second sensor arrangement may be provided separately from the controller.

Accordingly, the controller may use (for each measured phase current) both the measured current flowing through the secondary inductors, and the phase current in order to determine the generation of the overcurrent fault signal. That is, both the measured current flowing through the secondary conductors and the measured phase current may be used to determine whether to generate the overcurrent fault signal, and/or determine the type of overcurrent fault signal generated.

The second sensor arrangement may measure, for each phase input of at least two of the phase inputs, a phase current provided to the primary inductor connected to the respective phase input via the input node. In some cases, the second sensor arrangement may measure each phase current provided to each of the primary inductors. Each of the measured phase currents may then be used, individually, to generate the overcurrent fault signal. For instance, the overcurrent fault signal may be generated if any of the measured phase currents exceeds a certain threshold.

For example, during transient operation, a phase current provided to a first primary inductor of the plurality of primary inductors may be low and therefore may not result in the generation of an overcurrent fault signal. However, a phase current provided to a second primary inductor of the plurality of primary inductors may be high, and therefore an overcurrent fault signal is generated on this basis.

In other words, the overcurrent fault signal may be generated based on at least one of the measured phase currents meeting a certain criterion, rather than all of the phase currents (or even a majority) meeting the criteria. This means that each measured phase currents may be used individually to determine the generation of the overcurrent fault signal.

In some embodiments, the controller may be configured to generate the overcurrent fault signal further based on a static overcurrent protection threshold.

The static overcurrent protection threshold may define a target maximum current (e.g., a rated current) through each primary inductor. For example, the static overcurrent protection threshold may reflect the amount of current that may flow through the primary inductors before the primary inductors become saturated. This may indicate the amount of current that can be supported by the magnetising inductance of the primary inductor(s) before saturation is reached.

The static overcurrent protection threshold may be predetermined (i.e., set by a manufacturer), or may be programmed into the controller.

The static overcurrent protection threshold may be equal to a rated inductor saturation current of at least one of the primary inductors.

When the controller is configured to generate the overcurrent fault signal further based on at least one of the measured phase currents and a static overcurrent protection threshold, the controller may be configured to generate the fault signal responsive to at least one of the measured phase currents exceeding a sum of the static overcurrent protection threshold and the measured current flowing through the secondary inductors.

That is, the current flowing through the secondary inductors/secondary windings (indicative of the load current supported by the leakage current of each transformer) allows the current provided by the phase input to exceed the static overcurrent protection threshold without triggering an overcurrent fault signal.

Essentially, this may be formulated as the overcurrent fault signal being generated (i.e., the controller outputting an indication that the inductor may be, or may soon be, saturated) responsive to the condition:

$$i_{ph,i}(t) > i_{L_{secondary}}(t) + i_{static} \qquad [3]$$

Where $i_{static}$ is the static overcurrent protection threshold. Equally, the comparison may be conducted according to the following condition:

$$i_{ph,i}(t) - i_{L_{secondary}}(t) > i_{static} \qquad [4]$$

In all cases, the presence of the current flowing through the second inductors permits the phase currents provided to the primary inductors to exceed the static threshold without triggering the fault signal.

An exemplary controller may be configured to determine a dynamic overcurrent protection threshold based on a sum of the measured current flowing through the secondary inductors and the static overcurrent protection threshold. Then, the overcurrent fault signal may be generated responsive to at least one of the measured phase currents exceeding the dynamic overcurrent protection threshold.

That is, a threshold that is changeable with time may be generated, below which the current through the primary inductors should remain, to avoid saturation. This dynamic threshold can be used to adapt the point at which an overcurrent fault signal is generated.

In some embodiments, the first sensor arrangement may comprise a DC resistance current sensing circuit configured to measure the current flowing through the secondary inductors.

The DC resistance (DCR) current sensing circuit may comprise a resistor and a capacitor connected in series, which themselves are provided in parallel with the secondary inductors to measure the current flowing through the secondary inductors.

Alternatively, when the multi-phase trans-inductance voltage regulator further comprises a compensation inductor connected in series with the secondary inductors, the first sensor arrangement may comprise a DCR current sensing circuit configured to measure the current flowing through the secondary inductors and the compensation inductor.

In this case the DC resistance current sensing circuit is provided across the compensation inductor or across the compensation inductor and the secondary inductors.

That is, the DCR current sensing circuit may be provided in parallel with either the compensation inductor, or both the compensation inductor and the plurality of secondary inductors.

The compensation inductor may be added in series with the secondary inductors in order to adjust and more finely/accurately control the current slope in the secondary inductors. Whether the compensation inductor is included or not will thus depend on the various design requirements of the TLVR. However, the compensation inductor can be used to determine the current flowing through the secondary side, by providing a DCR sensing circuit across it.

If the compensation inductor is not provided, it may be desirable to provide the DCR sensing circuit across the whole trace upon which the secondary inductors are provided, in order to ensure a reliable determination of the current flowing through the secondary side.

The current measured by the DCR current sensing circuit may be output in the form of a voltage if the controller requires a voltage signal for processing.

In an exemplary embodiment, the first sensor arrangement may further comprise an amplifier to amplify an output of the DC resistance current sensing circuit. The amplifier may be an instrumentation amplifier.

As an alternative, the first sensor arrangement may comprise a transformer comprising a primary side connected in series with the secondary inductors, and a secondary side terminated by a resistor. The first sensor arrangement may comprise a voltage sensor configured to sense a voltage across the resistor on the secondary side.

That is, a primary inductor may be provided in series with the secondary inductors, and a primary inductor coupled to the secondary inductor. The primary inductor is terminated by a resistor to provide a readable voltage (e.g., if the controller requires a voltage signal rather than a current) indicative of current through the secondary inductors of the TLVR.

As yet another alternative, the first sensor arrangement may comprise a shunt resistor connected in series with the second inductors, and a voltage sensor configured to sense a voltage across the shunt resistor.

The first sensor arrangement in this case may also further comprise an amplifier configured to amplify the voltage across the shunt resistor. The amplifier may be an instrumentation amplifier.

While the first sensor arrangement comprising a shunt resistor is lossy, it may be more accurate than the transformer and DCR sensing means described above. The shunt resistor also contributes to an increase in the decay constant with which the current flowing through the secondary inductors drops to zero.

When the first sensor arrangement is configured to sense a voltage (e.g., a voltage across the shunt resistor, or a voltage across the resistor on the secondary side of the transformer), the controller may be configured to receive the sensed voltage, and determine the current flowing through the second inductors based on the sensed voltage.

In this case, the controller may comprise an analog-to-digital converter configured to convert the received sensed voltage to a numerical value describing the sensed voltage. To this end, the controller may comprise hardware suitable for converting sensed voltage to a numerical value, and then to determine the current flowing based on said numerical value.

Also provided is a multi-phase trans-inductance voltage regulator, comprising:

a plurality of transformers, each transformer comprising a primary inductor and a secondary inductor, wherein the primary inductor of each transformer is provided between a respective input node and a common output node, the secondary inductors of the plurality of transformers are connected in series, and wherein each input node is connected to a respective one of a plurality of phase inputs; and

a system for overcurrent protection as summarised above.

Accordingly, the TLVR provided by the invention may have a high current throughput without the need for increased inductor size. That is, by generating the overcurrent fault signal based (in part) on the current flowing through the secondary inductors, the current supported by the magnetizing inductance of the primary inductors may be accurately assessed.

When current flowing through the secondary inductors is high, this means that the load current supported by the leakage inductance of the transformers is high, resulting in a reduced current supported by the magnetizing inductance of the primary inductor. As the current supported by the magnetizing inductance is the relevant parameter for an overcurrent fault, a low current supported by this inductance means a low chance of saturation and thus an overcurrent fault.

The multi-phase trans-inductance voltage regulator may be any converter having an inductor-based topology in which current regulation is achieved by flux balancing of trans-inductors. For example, the multi-phase trans-inductance voltage regulator may have a topology based on a half-bridge, a full bridge, or a half-bridge with a current doubler rectifier. Suitable topologies can include both isolated and non-isolated topologies.

More specifically, the multi-phase trans-inductance voltage regulator may be a buck converter. In other words, the multi-phase trans-inductance voltage regulator may have a buck-derived topology.

Further provided is a method for overcurrent protection of a multi-phase trans-inductance converter. The multi-phase trans-inductance converter comprises a plurality of transformers, each transformer comprising a primary inductor and a secondary inductor. The primary inductor of each transformer is provided between a respective input node and a common output node, and the secondary inductors of the plurality of transformers are connected in series. Each input node is connected to a respective one of a plurality of phase inputs. The method comprises:

measuring a current flowing through the secondary inductors; and
generating an overcurrent fault signal based at least in part on the measured current flowing through the secondary inductors.

In addition, there is provided a controller for overcurrent protection of a multi-phase trans-inductance voltage regulator, the multi-phase trans-inductance voltage regulator comprising a plurality of transformers, each transformer comprising a primary inductor and a secondary inductor, wherein the primary inductor of each transformer is provided between a respective input node and a common output node, the secondary inductors of the plurality of transformers are connected in series, and wherein each input node is connected to a respective one of a plurality of phase inputs, the controller configured to:

obtain a measured current flowing through the secondary inductors; and
generate an overcurrent fault signal based at least in part on the measured current flowing through the secondary inductors.

BRIEF DESCRIPTION OF THE DRAWINGS

The invention will now be described by way of example with reference to the accompanying drawings, in which:

Fig. 1 is a circuit diagram showing a multi-phase trans-inductor voltage regulator (TLVR) according to a generalized example;
Fig. 2 is an equivalent circuit diagram of one of the transformers depicted in Fig. 1;
Fig. 3 is a circuit diagram showing the TLVR of Fig. 1 with the equivalent circuit of Fig. 2 applied;
Fig. 4 is a graph depicting waveforms of a single phase of the circuit of Fig. 3 during steady state operation;
Fig. 5 is a graph depicting waveforms of a single phase of the circuit of Fig. 3 during transient operation;
Fig. 6 is a simplified circuit diagram of the operation of the controller for overcurrent protection of a TLVR;
Fig. 7 is a circuit diagram showing a TLVR and a first sensor arrangement according to an example;
Fig. 8 is a circuit diagram showing a TLVR and a first sensor arrangement according to another example;
Fig. 9 depicts different options for sensing points of the first sensor arrangement of Fig. 8.
Fig. 10 is a circuit diagram showing a TLVR and a first sensor arrangement according to a further example;
Fig. 11 is a circuit diagram showing N-phases of a multi-phase buck converter with TLVR; and
Fig. 12 is a generalised block diagram of a TLVR for any inductor-based converter topology arranged for multi-phase operation.

It should be noted that these figures are diagrammatic and not drawn to scale. Relative dimensions and proportions of parts of these figures have been shown exaggerated or reduced in size, for the sake of clarity and convenience in the drawings.

DETAILED DESCRIPTION

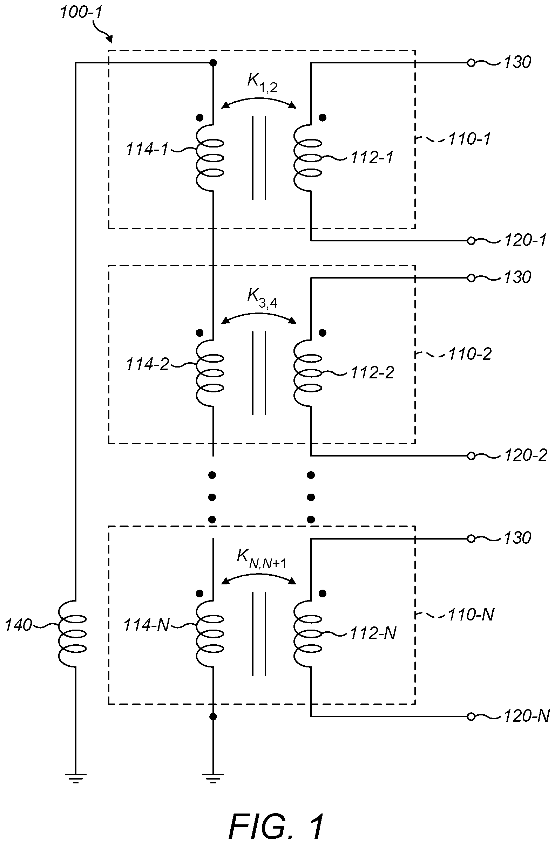

To understand the present disclosure, it is important to understand the operation of a multi-phase trans-inductor voltage regulator (TLVR). Fig. 1 is a circuit diagram of a TLVR 100-1.
The TLVR 100-1 comprises a plurality of transformers 110-1... 110-N. Each transformer 110-1... 110-N comprises a primary inductor 112-1... 112-N on a primary side of the TLVR 100-1, and a secondary inductor 114-1... 114-N on a secondary side of the TLVR 100-1. Each of the primary inductors 112-1... 112-N is provided between a respective input node 120-1... 120-N (connected to a respective phase input) and a common output node 130. That is, the primary inductors 112-1... 112-N are each connected to a different phase input, but are connected to a common output. Each of the secondary inductors 114-1... 114-N is connected/provided in series with the others, and collectively they are referenced to ground.
Accordingly, the TLVR 100-1 delivers power from an input voltage supplied in multiple phases, to a common output 130 that may be considered a point-of-load. Rather than using uncoupled individual inductors connected to each phase input (as in traditional voltage regulators), each phase input is input to a transformer 110-1... 110-N. The coupling between each primary inductor/winding 112-1... 112-N and each secondary inductor/winding 114-1... 114-N of the same transformer 110-1... 110-N may have a coupling coefficient close to unity, being near-perfect.
In some cases, each input node 120-1... 120-N may be connected to one or more switches. When multi-phase operation is used, all the phase inputs are coupled to enhance current slew rate during a variation of the root mean square (RMS) voltage on each input node 120-1... 120-N.
A controller of the TLVR 100-1 can be provided that controls the switching frequency and/or duty cycle of the switches connected to each input node 120-1... 120-N. The controller may output control signals to driving circuitry for the switches to control a phase input to each input node 120-1... 120-N.

When there is a load jump (i.e. an increase in the current/power required by the load), a pulse width modulation (PWM) duty cycle associated with one or more of the phase inputs (i.e. of the one or more switches connected to the input node 120-1... 120-N) may be increased. This may be performed by the above-mentioned controller.

For TLVR 100-1, as all of the phases are indirectly connected by the secondary inductors 114-1... 114-N provided in series, an increase in current provided in one phase input leads to an increase of output current in all phases. This feature of the TLVR 100-1 allows a faster transient response corresponding to a significantly lower effective output inductance of the system.

Optionally, the TLVR 100-1 may further comprise a compensation inductor 140 provided/connected in series with the secondary inductors 114-1... 114-N. The compensation inductor 140 may be designed to adjust the current slope in the secondary inductors 114-1... 114-N.

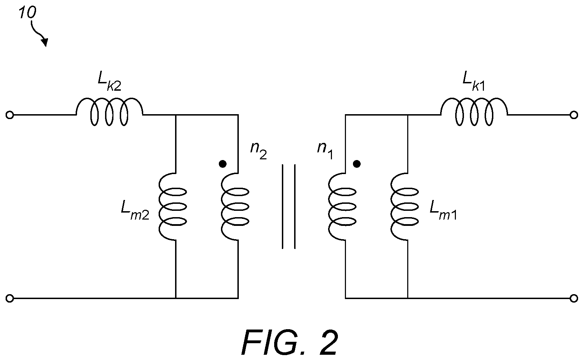

Referring now to Fig. 2, each of the transformers 110-1... 110-N (i.e., trans-inductors) may be described by the depicted equivalent circuit/model 10. The equivalent circuit 10 may be considered a classic transformer with a certain coupling (between primary and secondary windings/inductors), and with a magnetizing inductance, $L_{mi}$, and leakage inductance, $L_{k1}$.

By considering the equivalent circuit 10, the following equations can be established:

$$L_{m1} = k_{k_{1,2}} L_1 \qquad\qquad [5]$$

$$L_{k1} = (1 - k_{1,2}) L_1 \qquad\qquad [6]$$

$$L_{m2} = k_{1,2} L_2 \qquad\qquad [7]$$

$$L_{k2} = (1 - k_{1,2}) L_2 \qquad\qquad [8]$$

With $k_{i-1,i} > 0$, the turns ratio of the transformer has the following relation:

$$\frac{L_{m1}}{L_{m2}} = \left(\frac{n_1}{n_2}\right)^2 \qquad\qquad [9]$$

After the model analysis using the above equations, a voltage is induced on each input node that is proportional to the voltage being imposed by all the phases. In other words, each phase input to one transformer 110-1... 110-N boosts the other transformers 110-1... 110-N of the TLVR 100-1.

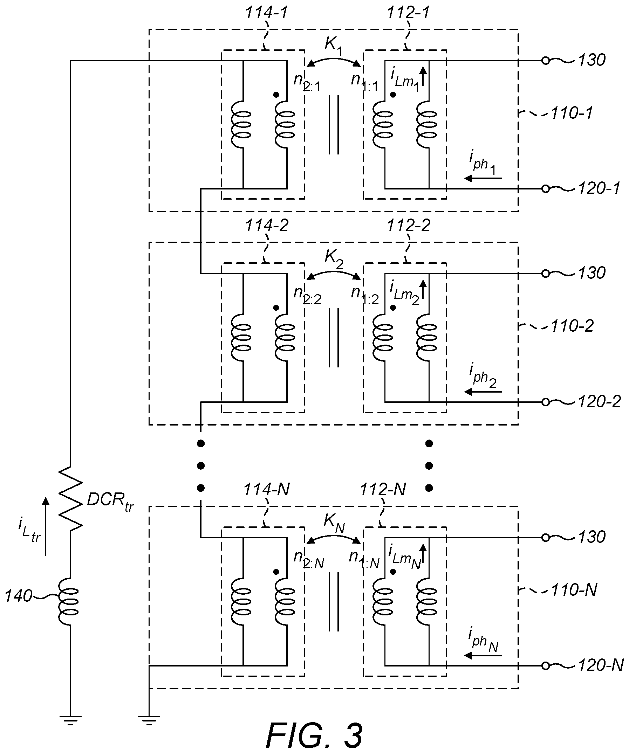

Fig. 3 presents an equivalent model 100-2 of the TLVR 100-1 of Fig. 1 merged with the equivalent model 10 of Fig. 2, assuming that $L_k \ll L_m$ for each transformer 110-1... 110-N.

Each secondary inductor 114-1... 114-N in the equivalent model 100-2 shown in Fig. 3 can be considered as an induced voltage source. When the voltage on an input node 120-1... 120-N, supplied by a phase input, is pulled to the input voltage potential (e.g., by turning on a high-side switch of a buck converter, connected to the input node 120-1... 120-N), there is a positive voltage applied to the magnetizing inductance of the primary inductor 112-1... 112-N. When the input node 120-1... 120-N is connected to GND potential (e.g., by switching off a high-side switch of a buck converter connected to the input node 120, and switching on a low-side switch of the buck converter), the voltage applied is negative. On each secondary inductor 114-1... 114-N, each voltage results in a changing current in the compensation inductor 140, shown as $i_{Ltr}$. When the secondary side current is changing, this will also give an upward or downward trend to the current supplied by each phase input.

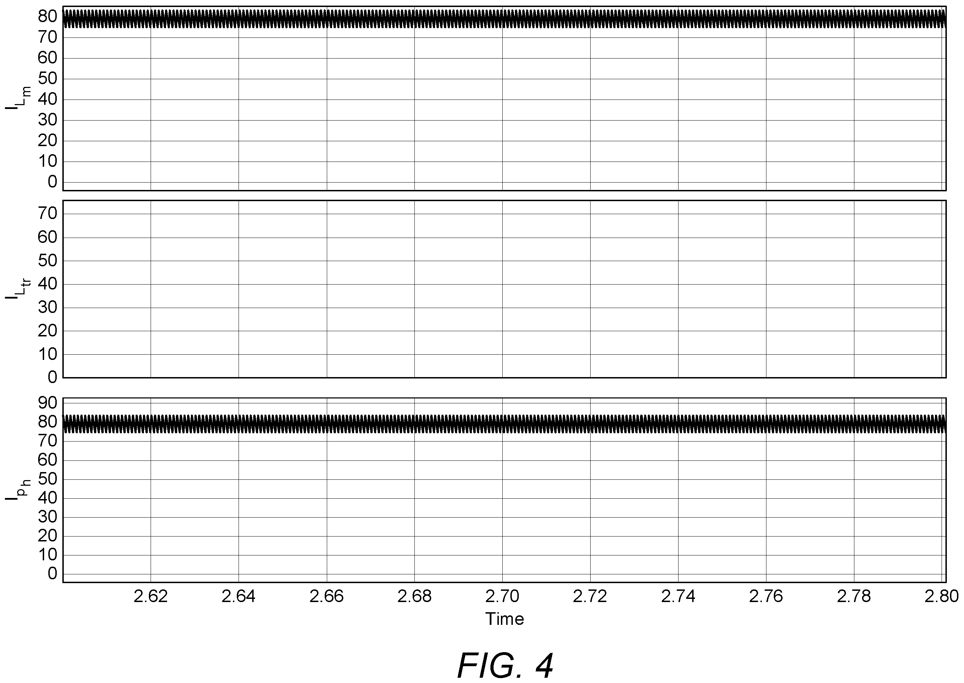

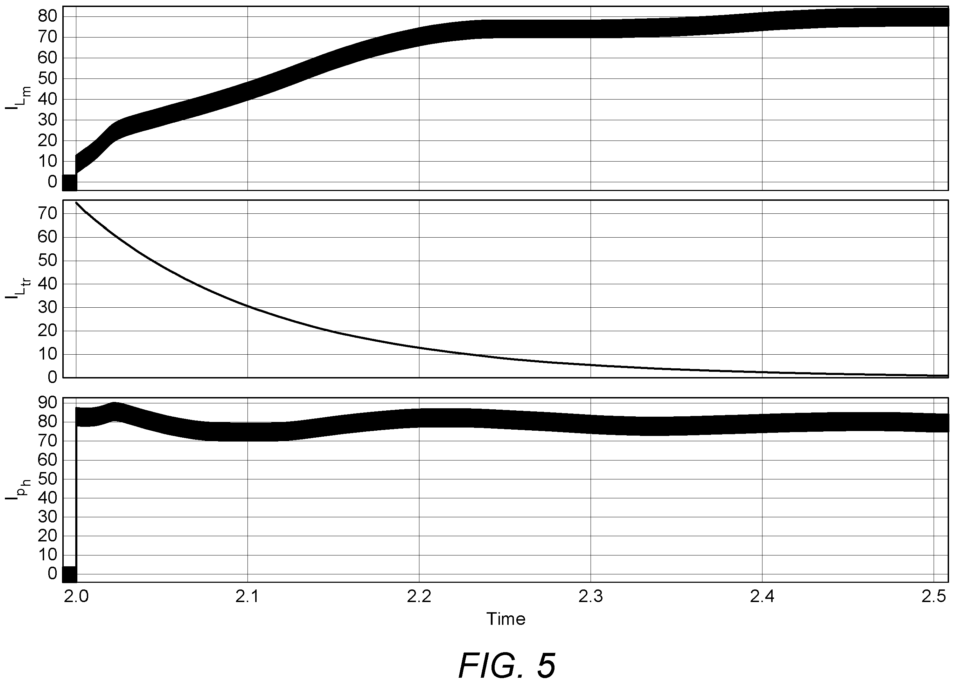

This operation can be further appreciated when considering Fig. 4 and Fig. 5, which show current waveforms flowing through different parts of the TLVR operating under steady-state (i.e. constant DC load) and transient conditions (i.e. when a load transition occurs), respectively. Specifically, the magnitude of current supported by the magnetizing inductance of the primary inductor 112-1... 112-N, $I_{Lm}$, current through the compensation inductor 140, $I_{Ltr}$, and current on the input node 120-1... 120-N, $I_{ph}$, are shown.

As seen in Fig. 4, when the TLVR is in steady state operation, the primary inductor 112-1... 112-N of each transformer carries a DC load current, $I_{Lm}$. The AC current component, flowing into each input node 120-1... 120-N, depends on the primary inductance current ripple, and on the current ripple of the compensation inductor 140. During steady state operation, the compensation inductor 140, and therefore the secondary inductors 114-1... 114-N, do not have any DC current flowing through them.

As seen in Fig. 5, when there is a load variation (i.e., a change in the current required by the load), a controller of switches connected to the input nodes 120-1... 120-N of each primary inductor 112-1... 112-N may change the duty-cycle of the switches to compensate for the output voltage variation, increasing $I_{ph}$. The reflected voltage on each transformer 110-1... 110-N charges the current on the secondary side, $I_{Ltr}$, with a slope dependent on the inductance of the compensation inductor 140 and the sum of all the secondary inductor voltages reflected from the primary side/primary inductors 112-1... 112-N. Then, the changing current flowing through the secondary inductors 114-1... 114-N connected in series also gives rise to an increase of current on each input node 120-1... 120-N of the primary inductors 112-1... 112-N.

During this time interval, the current flowing to the output node 130 is supported by the leakage current of each of the transformers 110-1... 110-N. Indeed, when the current built into the secondary inductors 114-1... 114-N increases quickly, this compensates part of the DC flux into the primary side magnetizing inductance necessary to withstand the actual load current.

Nevertheless, since the secondary inductors 114-1... 114-N and associated physical connections present a resistive behaviour due to inductor DCR resistance and distributed resistance of interconnection of all secondary inductors 114-1... 114-N and the ground path (represented as $DCR_{tr}$ in Fig. 3), the current, $I_{Ltr}$, through the secondary inductors 114-1... 114-N drops to zero with a certain decay constant. The decay constant depends on the following:

$$i_{L_{tr}}(t) = I_{L_{tr}}(t_0)e^{-\frac{DCR_{tr}}{L_{tr}+\sum_{i=1}^{N}\left(L_{k2,i}+L_{m2,i}\right)}} \qquad [10]$$

Where $L_{m2,i}$ is the magnetizing inductance on each secondary inductor, $L_{k2,i}$ is the secondary inductor leakage inductance, and $I_{Ltr}(t_0)$ is the peak current on the secondary side/through the secondary inductors during a load jump.

From this equation, the decay constant by which the current flowing through the secondary inductors decays following a load jump is known as:

$$\tau = \frac{DCR_{tr}}{L_{tr} + \sum_{i=1}^{N}\left(L_{k2,i} + L_{m2,i}\right)} \qquad [11]$$

By knowing this decay constant, an appropriate overcurrent protection strategy may be developed.

Furthermore, and considering the equivalent TLVR circuit in Fig. 3, the following is always valid:

$$i_{ph,i}(t) = i_{L_{tr}}(t) + i_{L_{m_{1,i}}}(t) \qquad [12]$$

This can be seen most clearly in Fig. 5. Essentially, the current $i_{Lm}$ built into the magnetizing inductance of the primary inductor 112-1... 112-N depends on the load jump and the above decay constant. Therefore, during a load jump, each individual primary inductor 112-1... 112-N of the TLVR 100-2 can withstand a current above the inductor saturation current for a certain amount of time that is dependent on the decay constant and magnitude of the load jump.

For some applications, it may be necessary to operate the TLVR 100-2 above a rated current (in particular, a rated current of one or more of the primary inductors) for a short time, due to a load-step. Usually, the TLVR 100-2 will only be operated above the rated current for a short amount of time, with the amount of time usually inversely proportional to the magnitude of the load current.

For example, the Open Compute Project (OCP) Accelerator Module (OAM) 2.0 specifications state that the voltage regulator must be able to handle/withstand instantaneous peak power above the average power absorbed by the digital load. Thus, when the TLVR 100-2 is utilized as a voltage regulator for an OAM-compliant module, it may be necessary to operate the TLVR 100-2 at 2x the thermal design power for less than 500μs, 1.6x the thermal design power for less than 2ms, and 1.2x the thermal design power for less than 10ms.

While TLVR 100-2 facilitates these temporary increases in peak power, it is worth noting that the amount of time spent above the rated current should be carefully controlled in light of the decay constant of the current flowing through the secondary inductors 114-1... 114-N. As described above, and seen in Figure 5, the amount of current flowing in the secondary inductors 114-1... 114-N decays according to a decay constant, $\tau$. This is reflective of the amount of time that the input to the TLVR 100-2 may remain above a rated current.

Put another way, TLVR 100-2 enables a temporary excursion of the load current above a rated current as the load current is supported by the leakage inductance in each of the transformers 110-1... 110-N. However, this increase in load current must be temporary as the current flowing through the secondary inductors 114-1... 114-N decays according to the decay constant, $\tau$. Thus, this decay constant should be designed to enable the current flowing through the secondary inductors 114-1... 114-N to remain above a required value for at least as long as a transient resulting from a load-step is present.

Examples according to the present disclosure are concerned with exploiting the above described physical behavior during transient operation of the TLVR 100. By sensing the current on the secondary side/flowing through the secondary inductors 114-1... 114-N, an appropriate overcurrent protection strategy (e.g., generation of an appropriate overcurrent fault signal) may be provided. In some implementations, by sensing the actual phase current on the input node 120 in addition to the current flowing through the secondary inductors 114-1... 114-N, it is possible to reconstruct the magnetizing current of each primary inductor 112-1... 112-N.

Usually, in inductor-based (i.e. non-trans-inductor based) voltage regulators, each phase is protected against overcurrent to avoid inductor saturation and/or silicon failure. This is usually implemented by a static overcurrent protection threshold (dependent on the inductors and power MOSFETs used to implement the regulator). Typical controllers sense the current provided by each phase input, to ensure current sharing and output voltage control. However, a controller according to the present disclosure additionally senses, or otherwise obtains, a measured current flowing through the secondary inductors 114-1... 114-N, and generates an overcurrent fault signal based, at least in part, on the measured current.

Examples according to the present disclosure additionally exploit knowledge of the current on the secondary side/flowing through the secondary inductors 114-1... 114-N. Thus, in contrast with controllers of a typical conventional multi-phase voltage regulator, examples according to the present disclosure additionally obtain a measurement of the current on the secondary side.

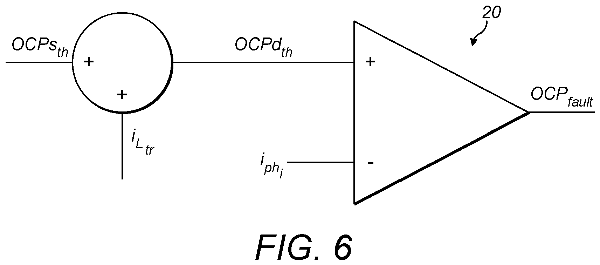

An aspect of the controller configured for generation of the overcurrent fault signal may operate according to the circuit diagram 10 presented in Fig. 6. In this case, a static overcurrent protection threshold and the (changeable) measured current flowing through the secondary inductors 114-1... 114-N are added in order to determine a dynamic overcurrent protection threshold. This dynamic overcurrent protection threshold is then compared with a phase current provided by one of the phase inputs (i.e., the current provided at the input node 120-1... 120-N of the primary inductor 112-1... 112-N). If the phase current exceeds the dynamic overcurrent protection threshold, then an overcurrent fault signal is generated.

This may be implemented for each transformer 110-1... 110-N of the TLVR. That is, each of the phase currents provided by the phase inputs may be individually compared to the dynamic overcurrent protection threshold to determine whether to generate the overcurrent fault signal.

The controller used to generate the overcurrent fault signal may be the same controller used to control the switching frequency and/or duty cycle of the switches connected to each input node 120-1... 120-N. Alternatively, the controller used to generate the overcurrent fault signal may be implemented with separate hardware to said switching controller. For example, the controller used to generate the overcurrent fault signal may be implemented in the analog domain, whereas the controller used for switching is typically digital.

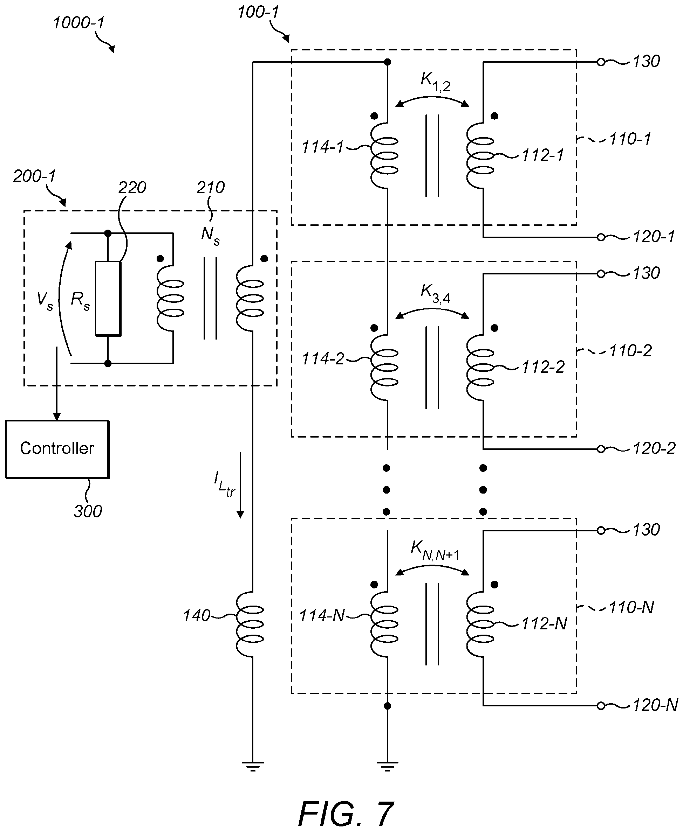

Moving on, Figs. 7-10 present various options and concepts related to the sensing/measurement of the current flowing through the secondary inductors 114-1... 114-N of TLVR 100-1. In each depicted case, the first sensor arrangement 200-1, 200-2, 200-3 outputs a voltage signal (representative of the measured current) to a controller 300 for generating an overcurrent fault signal based at least in part on the measured current.

Specifically, Fig. 7 presents a first sensor arrangement 200-1 that uses a current transformer 210 in series with the plurality of secondary inductors 114-1... 114-N (and the optional compensation inductor 140). A primary side of the transformer 210 (i.e. a primary inductor) is connected in series with the secondary inductors 114-1... 114-N. A secondary side of the transformer 210 may be terminated using a resistor 220 to convert the current information on the secondary side of the transformer 210 into voltage information. For example, this may be desirable when the controller requires a voltage signal.

With this method, the output voltage is proportional to the current flowing through the secondary inductors 114-1... 114-N according to the following equation:

$$V_s = N \cdot R_s \cdot I_{Ltr} \qquad [13]$$

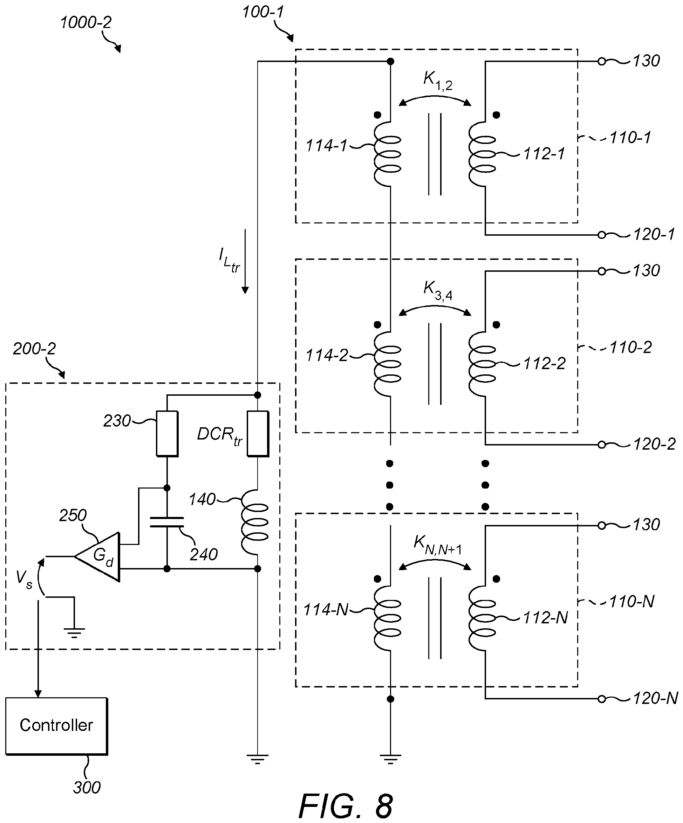

Fig. 8 shows another example of a first sensor arrangement 200-2, which uses a (lossless) DC resistance (DCR) current sensing circuit. All of the components on the secondary side of the TLVR 100-1, whether secondary inductors 114-1... 114-N, the compensation inductor 140, or any traces connecting the various components, have an intrinsic resistance. This intrinsic resistance used in order to measure current flowing through the secondary inductors 114-1... 114-N.

In one implementation the DCR sensing circuit uses a capacitor 240 and resistor 230 provided together in series, and connected across (at least a part of) the intrinsic resistance of the secondary side of the TLVR 100-1. This enables the sensing, across the capacitor 240, of a voltage signal that is proportional to the current flowing through the secondary inductors 114-1... 114-N.

An amplifier 250 (e.g., an instrumentation amplifier) may be used across the capacitor 240 to amplify said signal.

Accordingly, if the capacitance of the capacitor 240, and the resistance of the resistor 230 are properly selected, a voltage signal may be produced according to the following equation:

$$V_s = DCR_{tr} \cdot G_d \cdot I_{Ltr} \qquad [14]$$

Proper selection means that the capacitance and resistance must be chosen to cancel the voltage produced by the parasitic resistance, so that only the current-based voltage is measured.

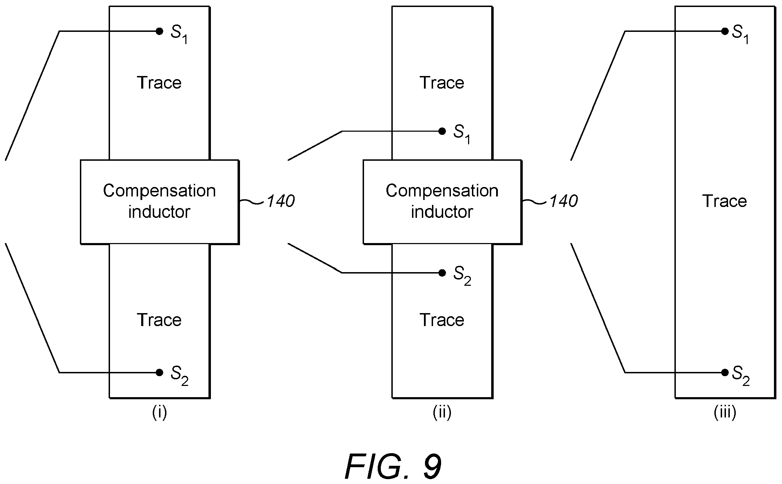

In a TLVR circuit 100-1, there is usually a long physical connection between the secondary inductors 114-1... 114-N and ground. As depicted in Fig. 9, the DCR current sensing circuit may be applied across (i.e. in parallel with) different parts of this connection.

In the case that a compensation inductor 140 is included on the secondary side, the DCR sensing circuit may be applied across the whole trace (i.e. physical connections) and the compensation inductor 140, as shown in (i). This may give the most accurate reading, as the DCR sensing circuit is applied across the largest DC resistance available. However, the parasitic resistances of the trace and the compensation inductor 140 may need to be measured, to ensure accurate results.

Alternatively, the DCR sensing circuit may be provided across the compensation inductor 140 only, as depicted in (ii). This may be ideal to ensure straightforward selection of the capacitance and resistance of the DCR sensing circuit as the DC resistance of the physical compensation inductor 140 may be well known (compared to the DCR of the full extent of the physical connection).

In some examples, TLVR 100-1 may not have a physical compensation inductor 140. In this case, it may be desirable to provide the DCR sensing circuit across as much of the secondary side of the TLVR 100-1 as possible, in order to maximize the parasitic resistance that the DCR sensing circuit is provided across. This case is depicted in (iii).

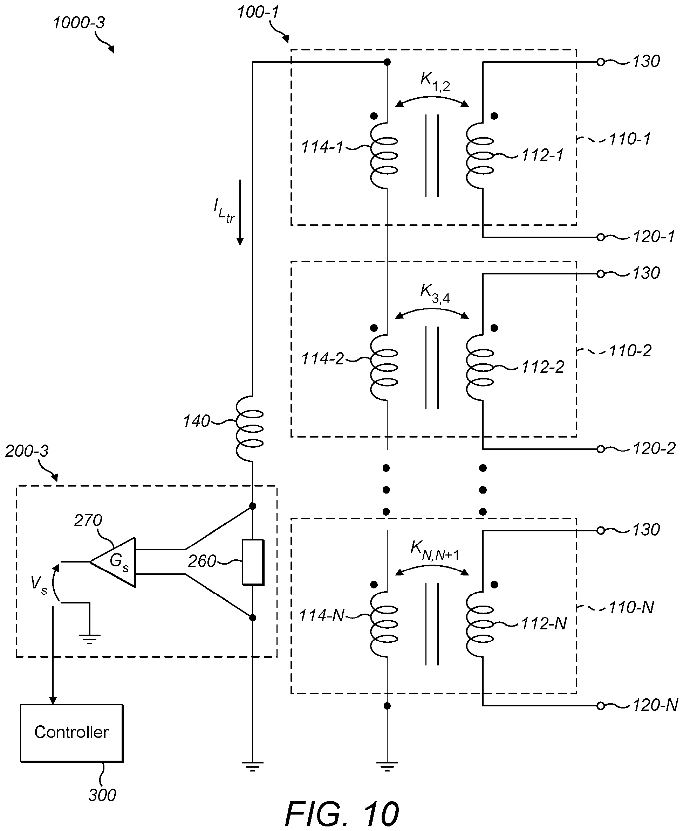

Fig. 10 presents an alternative first sensor arrangement 200-3, which uses a shunt resistor 260 placed in series with the secondary inductors 114-1... 114-N and (optional) compensation inductor 140. This sensor arrangement 200-3 is lossy due to the shunt resistor 260, but ensures the greatest accuracy of the sensor arrangements 200-1, 200-2, 200-3, described.

Furthermore, the shunt resistor 260 also contributes to the decay constant associated with the decay in the current flowing through the secondary inductors 114-1... 114-N. In essence, this means that the sensor arrangement 200-3 changes the behavior of the TLVR circuit 100-1.

An amplifier 270 (e.g., instrumentation amplifier) may be used to aid the sensing of the voltage across the shunt resistor 260, according to the following equation:

$$V_s = R_{shunt} \cdot G_s \cdot I_{Ltr} \qquad [15]$$

Of course, the above outlined current sensing strategies are not to be considered exhaustive or limiting. Any arrangement capable of determining the current flowing through the secondary inductors 114-1... 114-N may be employed.

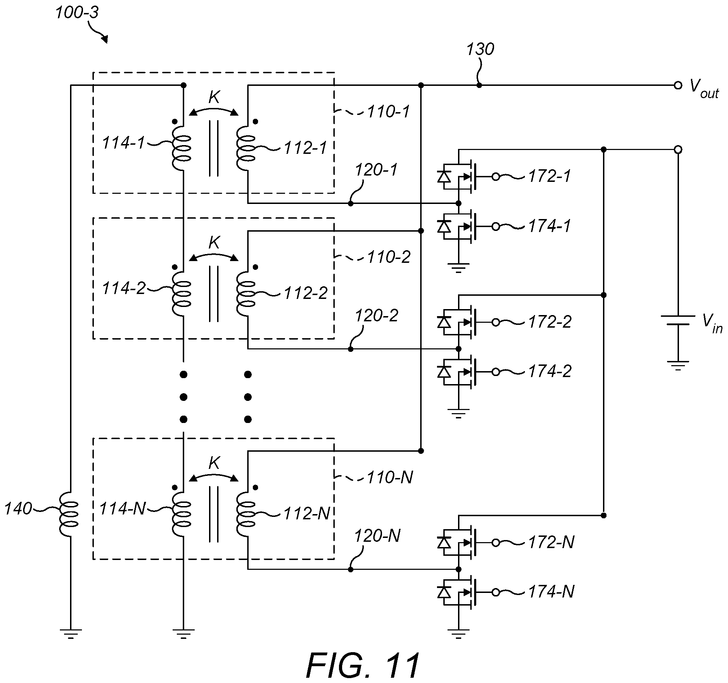

The proposed concepts for overcurrent protection may be applied to all trans-inductance based converters. The circuit presented in Fig. 11 presents one example of a TLVR 100-3 that may be suitable for use in high current demand applications, such as data centres.

Specifically, Fig. 11 is a circuit diagram showing a N-phases of a multi-phase buck converter with TLVR 100-3. As shown, the input node 120-1... 120-N for each respective transformer 110-1... 110-N is connected to a switch node between two switches. One switch is a low-side switch 174-1... 174-N connected to ground, and the other switch is a high-side switch 172-1... 172-N connected to the supply voltage. The switches (provided by MOSFETs, in this example) may be driven by a controller so that a phase input is provided at the input node 120-1... 120-N. The output node 120-1... 120-N of each transformer 110-1... 110-N is connected to a common output node 130, which may be connected to a load.

A transient experienced at the input node 120-1... 120-N of only one transformer 110-1... 110-N (i.e., applied in only one phase) is magnetically reflected to the secondary inductor/winding 114-1... 114-N, and through this is coupled to the other transformers/phases 110-1... 110-N. This enables the overcurrent protection method described above, since the transient current is initially sustained by the leakage inductance of each transformer 110-1... 110-N.

Nevertheless, the above-described concepts can be applied to any voltage regulator that includes a trans-inductor. Fig, 12 is a generalized diagram of a TLVR 100-4 to which the described concepts for overcurrent fault protection may be applied. Any converter topology that uses inductors may be able to use the trans-inductor concept, and any converter that uses the trans-inductor concept may be able to use the described overcurrent protection method to apply a dynamic/variable overcurrent protection threshold.

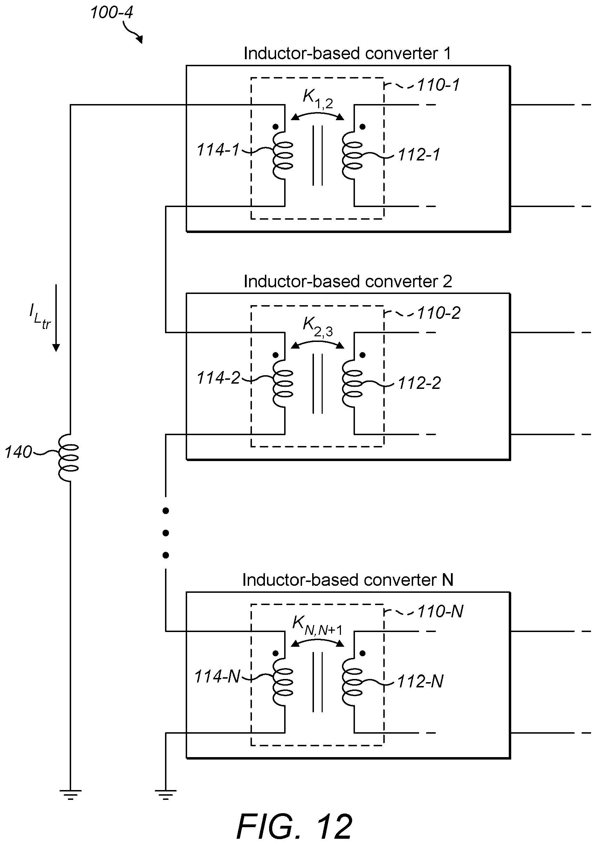

A first sensor arrangement 200-1, 200-2, 200-3 (such as those described in reference to Figs. 7-10) may be provided with the TLVR 100-4 of Fig. 12 to sense a current flowing through secondary inductors 114-1... 114-N of transformers contained in the inductor-based converters). An output from the first sensor arrangement is sent to a controller 300 for determining the generation of an overcurrent fault signal.

In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. The embodiments may be implemented by means of hardware comprising several distinct elements. In a device claim enumerating several means, several of these means may be embodied by one and the same item of hardware. The mere fact that certain measures are recited in mutually different dependent claims does not indicate that a combination of these measures cannot be used to advantage. Furthermore in the appended claims lists comprising "at least one of: A; B; and C" should be interpreted as (A and/or B) and/or C.

Embodiments as discussed herein may be practiced in various components such as integrated circuit modules. The design of integrated circuits is by and large a highly automated process. Complex and powerful software tools are available for converting a logic level design into a semiconductor circuit design ready to be etched and formed on a semiconductor substrate.

Programs, such as those provided by Synopsys, Inc. of Mountain View, California and Cadence Design, of San Jose, California automatically route conductors and locate components on a semiconductor chip using well established rules of design as well as libraries of pre-stored design modules. Once the design for a semiconductor circuit has been completed, the resultant design, in a standardized electronic format (e.g., Opus, GDSII, or the like) may be transmitted to a semiconductor fabrication facility or "fab" for fabrication.

The following embodiments are disclosed:

1. A system (1000-1, 1000-2, 1000-3) for overcurrent protection of a multi-phase trans-inductance voltage regulator (100-1, 100-2, 100-3, 100-4), the multi-phase trans-inductance voltage regulator comprising a plurality of transformers (110-1, 110-2, 100-N), each transformer comprising a primary inductor (112-1, 112-2, 112-N) and a secondary inductor (114-1, 114-2, 114-N), wherein the primary inductor of each transformer is provided between a respective input node (120-1, 120-2, 120-N) and a common output node (130), the secondary inductors of the plurality of transformers are connected in series, and wherein each input node is connected to a respective one of a plurality of phase inputs, the system comprising:

   a first sensor arrangement (200-1, 200-2, 200-3) configured to measure a current flowing through the secondary inductors; and
   a controller (300) configured to generate an overcurrent fault signal based at least in part on the measured current flowing through the secondary inductors.

2. The system of embodiment 1, further comprising a second sensor arrangement configured, for each of at least two of the plurality of phase inputs, to measure a phase current provided by the phase input, and wherein the controller (300) is configured to generate the overcurrent fault signal further based on at least one of the measured phase currents.

3. The system of embodiment 1 or 2, wherein the controller (300) is configured to generate the overcurrent fault signal further based on a static overcurrent protection threshold.

4. The system of embodiment 2, wherein the controller (300) is configured to generate the overcurrent fault signal further based on a static overcurrent protection threshold, and wherein the controller is configured to generate the fault signal responsive to at least one of the measured phase currents exceeding a sum of the static overcurrent protection threshold and the measured current flowing through the secondary inductors (114-1, 114-2, 114-N).

5. The system of embodiment 4, wherein the controller (300) is configured to:

   determine a dynamic overcurrent protection threshold based on a sum of the measured current flowing through the secondary inductors (114-1, 114-2, 114-N) and the static overcurrent protection threshold; and
   generate the overcurrent fault signal responsive to at least one of the measured phase currents exceeding the dynamic overcurrent protection threshold.

6. The system of any of embodiments 1-5, wherein the first sensor arrangement (200-1) comprises a DC resistance current sensing circuit configured to measure the current flowing through the secondary inductors (114-1, 114-2, 114-N).

7. The system of any of embodiments 1-5, wherein the multi-phase trans-inductance voltage regulator (100-1, 100-2, 100-3, 100-4) further comprises a compensation inductor (140) connected in series with the secondary inductors (114-1, 114-2, 114-N), and wherein the first sensor arrangement (200-2) comprises:
a DC resistance current sensing circuit configured to measure the current flowing through the secondary inductors and the compensation inductor.

8. The system of embodiment 7, wherein the DC resistance current sensing circuit is provided across the compensation inductor (140).

9. The system of embodiment 7, wherein the DC resistance current sensing circuit is provided across the compensation inductor (140) and the secondary inductors (114-1, 114-2, 114-N).

10. The system of any of embodiments 6-9, wherein the first sensor arrangement (200-2) further comprises an amplifier (250) to amplify an output of the DC resistance current sensing circuit.

11. The system of any of embodiments 1-5, wherein the first sensor arrangement (200-1) comprises:

a transformer (210) comprising a primary side connected in series with the secondary inductors (114-1, 114-2, 114-N), and a secondary side terminated by a resistor (220); and
a voltage sensor configured to sense a voltage across the resistor.

12. The system of any of embodiments 1-5, wherein the first sensor arrangement (200-3) comprises:

a shunt resistor (260) connected in series with the secondary inductors (114-1, 114-2, 114-N);
a voltage sensor configured to sense a voltage across the shunt resistor.

13. The system of embodiment 12, wherein the first sensor arrangement (200-3) further comprises an amplifier (270) configured to amplify the voltage across the shunt resistor (260).

14. The system of embodiment 10 or 13, wherein the amplifier (250, 270) is an instrumentation amplifier.

15. The system of any of embodiments 11-14, wherein the controller (300) is configured to:

receive the sensed voltage; and
determine the current flowing through the second inductors (114-1, 114-2, 114-N) based on the sensed voltage.

16. The system of any of embodiments 1-15, wherein the static overcurrent protection threshold is equal to a rated inductor saturation current of at least one of the primary inductors (112-1, 112-2, 112-N).

17. A multi-phase trans-inductance voltage regulator, comprising:

a plurality of transformers (110-1, 110-2, 110-N), each transformer comprising a primary inductor (112-1, 112-2, 112-N) and a secondary inductor (114-1, 114-2, 114-N), wherein the primary inductor of each transformer is provided between a respective input node (120-1, 120-2, 120-N) and a common output node (130), the secondary inductors of the plurality of transformers are connected in series, and wherein each input node is connected to a respective one of a plurality of phase inputs; and
a system (1000-1, 1000-2, 1000-3) for overcurrent protection according to any of embodiments 1-16.

18. The multi-phase trans-inductance voltage regulator (100-1, 100-2, 100-3, 100-4) of embodiment 17, wherein the multi-phase trans-inductance voltage regulator is a buck converter.

19. A method for overcurrent protection of a multi-phase trans-inductance voltage regulator (100-1, 100-2, 1003, 100-4), the multi-phase trans-inductance voltage regulator comprising a plurality of transformers (110-1, 110-2, 110-N), each transformer comprising a primary inductor (112-1, 112-2, 112-N) and a secondary inductor (114-1, 114-2, 114-N), wherein the primary inductor of each transformer is provided between a respective input node (120-1, 120-2, 120-N) and a common output node (130), the secondary inductors of the plurality of transformers are connected in series, and wherein each input node is connected to a respective one of a plurality of phase inputs, the method comprising:

measuring a current flowing through the secondary inductors; and
generating an overcurrent fault signal based at least in part on the measured current flowing through the secondary inductors.

20. A controller (300) for overcurrent protection of a multi-phase trans-inductance voltage regulator (100-1, 100-2, 1003, 100-4), the multi-phase trans-inductance voltage regulator comprising a plurality of transformers (110-1, 110-2, 110-N), each transformer comprising a primary inductor (112-1, 112-2, 112-N) and a secondary inductor (114-1, 114-2, 114-N), wherein the primary inductor of each transformer is provided between a respective input node (120-1, 120-2, 120-N) and a common output node (130), the secondary inductors of the plurality of transformers are connected in series, and wherein each input node is connected to a respective one of a plurality of phase inputs, the controller configured to:

obtain a measured current flowing through the secondary inductors; and
generate an overcurrent fault signal based at least in part on the measured current flowing through the secondary inductors.

**Claims**

1. A system (1000-1, 1000-2, 1000-3) for overcurrent protection of a multi-phase trans-inductance voltage regulator (100-1, 100-2, 100-3, 100-4), the multi-phase trans-inductance voltage regulator comprising a plurality of transformers (110-1, 110-2, 100-N), each transformer comprising a primary inductor (112-1, 112-2, 112-N) and a secondary inductor (114-1, 114-2, 114-N), wherein the primary inductor of each transformer is provided between a respective input node (120-1, 120-2, 120-N) and a common output node (130), the secondary inductors of the plurality of transformers are connected in series, and wherein each input node is connected to a respective one of a plurality of phase inputs, the system comprising:

a first sensor arrangement (200-1, 200-2, 200-3) configured to measure a current flowing through the secondary inductors; and
a controller (300) configured to generate an overcurrent fault signal based at least in part on the measured current flowing through the secondary inductors.

2. The system of claim 1, further comprising a second sensor arrangement configured, for at least two of the plurality of phase inputs, to measure a phase current provided by the respective phase input, and wherein the controller (300) is configured to generate the overcurrent fault signal further based on at least one of the measured phase currents.

3. The system of claim 1 or 2, wherein the controller (300) is configured to generate the overcurrent fault signal further based on a static overcurrent protection threshold.

4. The system of claim 2, wherein the controller (300) is configured to generate the overcurrent fault signal further based on a static overcurrent protection threshold, and wherein the controller is configured to generate the fault signal responsive to at least one of the measured phase currents exceeding a sum of the static overcurrent protection threshold and the measured current flowing through the secondary inductors (114-1, 114-2, 114-N).

5. The system of claim 4, wherein the controller (300) is configured to:

determine a dynamic overcurrent protection threshold based on a sum of the measured current flowing through the secondary inductors (114-1, 114-2, 114-N) and the static overcurrent protection threshold; and
generate the overcurrent fault signal responsive to at least one of the measured phase currents exceeding the dynamic overcurrent protection threshold.

6. The system of any of claims 1-5, wherein the first sensor arrangement (200-1, 200-2, 200-3) comprises a DC resistance current sensing circuit configured to measure the current flowing through the secondary inductors (114-1, 114-2, 114-N).

7. The system of any of claims 1-5, wherein the multi-phase trans-inductance voltage regulator (100-1, 100-2, 100-3, 100-4) further comprises a compensation inductor (140) connected in series with the secondary inductors (114-1, 114-2, 114-N), and wherein the first sensor arrangement (200-1, 200-2, 200-3) comprises:
a DC resistance current sensing circuit configured to measure the current flowing through the secondary inductors and the compensation inductor.

8. The system of claim 7, wherein the DC resistance current sensing circuit is provided across the compensation inductor (140).

9. The system of claim 7, wherein the DC resistance current sensing circuit is provided across the compensation inductor (140) and the secondary inductors (114-1, 114-2, 114-N).

10. The system of any of claims 1-5, wherein the first sensor arrangement (200-1, 200-2, 200-3) comprises:

   a transformer (210) comprising a primary side connected in series with the secondary inductors (114-1, 114-2, 114-N, and a secondary side terminated by a resistor (220); and
   a voltage sensor configured to sense a voltage across the resistor.

11. The system of any of claims 1-5, wherein the first sensor arrangement (200-1, 200-2, 200-3) comprises:

   a shunt resistor (260) connected in series with the secondary inductors (114-1, 114-2, 114-N);
   a voltage sensor configured to sense a voltage across the shunt resistor.

12. The system of claim 10 or 11, wherein the controller (300) is configured to:

   receive the sensed voltage; and
   determine the current flowing through the second inductors (114-1, 114-2, 114-N) based on the sensed voltage.

13. A multi-phase trans-inductance voltage regulator, comprising:

   a plurality of transformers (110-1, 110-2, 110-N), each transformer comprising a primary inductor (112-1, 112-2, 112-N) and a secondary inductor (114-1, 114-2, 114-N), wherein the primary inductor of each transformer is provided between a respective input node (120-1, 120-2, 120-N) and a common output node (130), the secondary inductors of the plurality of transformers are connected in series, and wherein each input node is connected to a respective one of a plurality of phase inputs; and
   a system (1000-1, 1000-2, 1000-3) for overcurrent protection according to any of claims 1-12.

14. A method for overcurrent protection of a multi-phase trans-inductance voltage regulator (100-1, 100-2, 1003, 100-4), the multi-phase trans-inductance voltage regulator comprising a plurality of transformers (110-1, 110-2, 110-N), each transformer comprising a primary inductor (112-1, 112-2, 112-N) and a secondary inductor (114-1, 114-2, 114-N), wherein the primary inductor of each transformer is provided between a respective input node (120-1, 120-2, 120-N) and a common output node (130), the secondary inductors of the plurality of transformers are connected in series, and wherein each input node is connected to a respective one of a plurality of phase inputs, the method comprising:

   measuring a current flowing through the secondary inductors; and
   generating an overcurrent fault signal based at least in part on the measured current flowing through the secondary inductors.

15. A controller (300) for overcurrent protection of a multi-phase trans-inductance voltage regulator (100-1, 100-2, 1003, 100-4), the multi-phase trans-inductance voltage regulator comprising a plurality of transformers (110-1, 110-2, 110-N), each transformer comprising a primary inductor (112-1, 112-2, 112-N) and a secondary inductor (114-1, 114-2, 114-N), wherein the primary inductor of each transformer is provided between a respective input node (120-1, 120-2, 120-N) and a common output node (130), the secondary inductors of the plurality of transformers are connected in series, and wherein each input node is connected to a respective one of a plurality of phase inputs, the controller configured to:

   obtain a measured current flowing through the secondary inductors; and
   generate an overcurrent fault signal based at least in part on the measured current flowing through the secondary

inductors.

FIG. 1

FIG. 2

FIG. 3

*FIG. 4*

FIG. 5

$OCPs_{th}$ + + $OCPd_{th}$ + $OCP_{fault}$

$i_{L_{tr}}$

$i_{ph_i}$ -

20

## FIG. 6

FIG. 7

*FIG. 8*

FIG. 9

FIG. 10

*FIG. 11*

_100-4_

Inductor-based converter 1

_~110-1_

$K_{1,2}$

_114-1_          _112-1_

$I_{L_{tr}}$

Inductor-based converter 2

_~110-2_

$K_{2,3}$

_114-2_          _112-2_

_140_

Inductor-based converter N

_~110-N_

$K_{N,N+1}$

_114-N_          _112-N_

_FIG. 12_

Europäisches
Patentamt

European
Patent Office

Office européen
des brevets

# EUROPEAN SEARCH REPORT

Application Number

EP 23 19 7916

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/109368 A1 (ZHOU YONG [US] ET AL) 7 April 2022 (2022-04-07) <br> * abstract * <br> * paragraph [0048] * <br> * paragraph [0060] - paragraph [0063] * <br> * paragraph [0072] - paragraph [0075] * <br> ----- | 1-15 | INV. <br> H02H7/12 |
| A | US 2023/049859 A1 (CAPETILLO RICARDO [US]) 16 February 2023 (2023-02-16) <br> * paragraph [0022] - paragraph [0026] * <br> * paragraph [0029] - paragraph [0035] * <br> * paragraph [0050] * <br> * claim 15 * <br> ----- | 1-15 | |
| A | CN 116 418 241 A (CHENGDU MONOLITHIC POWER SYS) 11 July 2023 (2023-07-11) <br> * abstract * <br> * figure 1 * <br> * the whole document * <br> ----- | 1-15 | |

TECHNICAL FIELDS
SEARCHED (IPC)

H02H
H02M

The present search report has been drawn up for all claims

| Place of search | Date of completion of the search | Examiner |
|---|---|---|
| Munich | 26 February 2024 | Operti, Antonio |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

......................................................................................

& : member of the same patent family, corresponding document

EPO FORM 1503 03.82 (P04C01)

EP 4 525 238 A1

**ANNEX TO THE EUROPEAN SEARCH REPORT
ON EUROPEAN PATENT APPLICATION NO.**

EP 23 19 7916

This annex lists the patent family members relating to the patent documents cited in the above-mentioned European search report.
The members are as contained in the European Patent Office EDP file on
The European Patent Office is in no way liable for these particulars which are merely given for the purpose of information.

26-02-2024

| Patent document cited in search report | | | Publication date | Patent family member(s) | | | Publication date |
|---|---|---|---|---|---|---|---|
| US 2022109368 | A1 | | 07-04-2022 | CN | 114389455 | A | 22-04-2022 |
| | | | | EP | 3979482 | A1 | 06-04-2022 |
| | | | | US | 2022109368 | A1 | 07-04-2022 |
| US 2023049859 | A1 | | 16-02-2023 | CN | 115133790 | A | 30-09-2022 |
| | | | | TW | 202307609 | A | 16-02-2023 |
| | | | | US | 2023049859 | A1 | 16-02-2023 |
| CN 116418241 | A | | 11-07-2023 | CN | 116418241 | A | 11-07-2023 |
| | | | | TW | 202338867 | A | 01-10-2023 |
| | | | | US | 2023299687 | A1 | 21-09-2023 |

EPO FORM P0459

For more details about this annex : see Official Journal of the European Patent Office, No. 12/82